# EUROPEAN PATENT APPLICATION

(11) **EP 4 760 294 A1**
(43) Date of publication of application: **17.06.2026**
(21) Application number: 25790750.1
(22) Date of filing: 04.03.2025
(51) Int. Cl.: G01R 31/367, G01R 31/392, G01R 31/396, G01R 31/382, G01R 31/36, G06F 17/18, G06F 16/904

(54) **BATTERY DIAGNOSTIC DEVICE AND OPERATING METHOD THEREOF**

(30) Priority: 17.04.2024 KR 20240051325
(71) Applicant: LG Energy Solution, Ltd., Seoul 07335 (KR)
(72) Inventor: CHUN, Joo Young, Daejeon 34122 (KR)
(74) Representative: Plasseraud IP
(86) International application number: PCT/KR2025/099541
(87) International publication number: WO 2025/221126

(57) **Abstract**

A battery diagnosis device according to an embodiment disclosed in this document includes an interface configured to acquire voltage data of a battery cell, and a processor configured to compute a distance between visualization data of a polynomial extracted based on the voltage data and visualization data of a previously stored reference polynomial, and detect abnormal voltage data based on a comparison result between the distance and a reference distance.

## Description

### TECHNICAL FIELD

### Cross-reference to Related Applications

This application claims priority from Korean Patent Application No. 10-2024-0051325, filed on April 17, 2024, the disclosure of which is incorporated by reference herein.

### Technical Field

Embodiments disclosed in this document relate to a battery diagnosis device and operating method thereof.

### BACKGROUND ART

Recently, research and development on secondary batteries have been actively conducted. Here, secondary batteries are batteries that can be charged and discharged, and may be interpreted including both conventional Ni/Cd batteries, Ni/MH batteries, and recent lithium ion batteries. Among secondary batteries, lithium ion batteries have the advantage of having much higher energy density than conventional Ni/Cd batteries and Ni/MH batteries, etc. In addition, lithium ion batteries may be manufactured to be small and lightweight, and thus lithium ion batteries are used as power sources for mobile devices. Recently, the scope of use of the lithium ion batteries has expanded to include a power source for electric vehicles, and the lithium ion batteries are attracting attention as a next-generation energy storage medium. Secondary batteries may be implemented as battery cells, battery modules, or battery packs.

Here, the open circuit voltage (OCV) of battery cells is used to estimate a charging capacity of battery cells, estimate the remaining life, or perform various battery management functions such as a cell balancing function. Therefore, there is a need to distinguish intact open circuit voltage data required to perform the management function of the battery cells among the open circuit voltage data of the battery cells.

### DISCLOSURE OF THE INVENTION

### TECHNICAL PROBLEM

Embodiments disclosed in this document provide a battery diagnosis device for identifying normal open circuit voltage data and an operating method thereof.

The technical objectives of the embodiments disclosed in this document are not limited to the technical problems mentioned above, and other technical problems not mentioned can be clearly understood by those skilled in the art from the descriptions below.

### TECHNICAL SOLUTION

A battery diagnosis device according to an embodiment disclosed in this document includes an interface configured to acquire voltage data of a battery cell, and a processor configured to compute a distance between visualization data of a polynomial extracted based on the voltage data and visualization data of a previously stored reference polynomial, and detect abnormal voltage data based on a comparison result between the distance and a reference distance.

According to an embodiment, the processor may be configured to divide the voltage data into a plurality of sub-voltage data according to a state of charge (SoC) of the battery cell, and calculate a slope of each of a plurality of linear regression equations acquired by inputting each sub-voltage data into a linear regression analysis model.

According to an embodiment, the processor may be configured to derive the visualization data by inputting the slope of each of the plurality of linear regression equations into a polynomial regression analysis model.

According to an embodiment, the visualization data may include data related to a graph of a polynomial derived by inputting the slope of each of the plurality of linear regression equations into the polynomial regression analysis model.

According to an embodiment, the processor may be configured to compute a distance between the visualization data of the polynomial and the visualization data of the reference polynomial based on a dynamic time warping (DTW) algorithm.

According to an embodiment, the processor may be configured to calculate a distance parameter by taking a reciprocal of each of the computed distances, and detect the abnormal voltage data based on a comparison result between the distance parameter and a reference distance parameter calculated based on the reference distance.

According to an embodiment, the voltage data of the battery cell may include data related to an open circuit voltage (OCV) of the battery cell at the middle of life (MOL).

According to an embodiment, the visualization data of the reference polynomial may include data related to a graph of a polynomial derived by dividing an open circuit voltage (OCV) graph of a battery cell at the beginning of life (BOL) into a plurality of sub-voltage data according to a state of charge (SoC) of the battery cell, calculating a slope of each of a plurality of linear regression equations by inputting each sub-voltage data into a linear regression analysis model, and inputting the slope of each of the plurality of linear regression equations into a polynomial regression analysis model.

An operating method of a battery diagnosis device according to an embodiment disclosed in this document, includes acquiring voltage data of a battery cell, computing a distance between visualization data of a polynomial extracted based on the voltage data and visualization data of a previously stored reference polynomial, and detecting abnormal voltage data based on a comparison result between the distance and a reference distance.

According to an embodiment, the computing of the distance may include dividing the voltage data into a plurality of sub-voltage data according to a state of charge (SoC) of the battery cell, calculating a slope of each of a plurality of linear regression equations acquired by inputting each of the plurality of sub-voltage data into a linear regression analysis model, and deriving the visualization data of the polynomial based on the slope of each of the plurality of linear regression equations.

According to an embodiment, the visualization data of the polynomial may include data related to a graph of a polynomial derived by inputting the slope of each of the plurality of linear regression equations into a polynomial regression analysis model.

According to an embodiment, the computing of the distance may include computing a distance between the visualization data of the polynomial and the visualization data of the reference polynomial based on a dynamic time warping (DTW) algorithm.

According to an embodiment, the voltage data of the battery cell may include data related to an open circuit voltage (OCV) of the battery cell at the middle of life (MOL).

According to an embodiment, the reference polynomial may include data related to a graph of a polynomial acquired by dividing an open circuit voltage (OCV) graph of a battery cell at the beginning of life (BOL) into a plurality of sub-voltage data according to the state of charge (SoC) of the battery cell, calculating a slope of each of a plurality of linear regression equations by inputting each sub-voltage data into a linear regression analysis model, and inputting the slope of each of the plurality of linear regression equations into a polynomial regression analysis model.

### ADVANTAGEOUS EFFECTS

The battery diagnosis device according to an embodiment disclosed in this document can distinguish between normal open circuit voltage data and abnormal open circuit voltage data among open circuit voltage data of a battery cell.

Technical effects according to an embodiment disclosed in this document are not limited to the effects mentioned above, and other effects not mentioned will be clearly understood by those skilled in the art according to the disclosure of this document.

### BRIEF DESCRIPTION OF THE DRAWINGS

FIG. 1 is a diagram for describing a battery diagnosis device and peripheral configuration thereof according to an embodiment disclosed in this document.
FIG. 2 is a diagram for describing a process of processing voltage data according to an embodiment disclosed in this document.
FIG. 3 is a graph for describing a process of deriving a slope of a linear regression equation according to an embodiment disclosed in this document.
FIG. 4 is a graph for describing a process of deriving visualization data according to an embodiment disclosed in this document.
FIG. 5 is a graph for describing a process of computing a distance according to an embodiment disclosed in this document.
FIG. 6 is a graph for describing a process of detecting abnormal voltage data according to an embodiment disclosed in this document.
FIG. 7 is a flowchart for describing an operation of a battery diagnosis device according to an embodiment disclosed in this document.
FIG. 8 is a diagram for describing a computing system equipped with a battery diagnosis device according to an embodiment disclosed in this document.

### MODE FOR CARRYING OUT THE INVENTION

Hereinafter, embodiments disclosed in this document will be described in detail with exemplary drawings. When adding reference numerals to components in each drawing, it should be noted that the same components are given the same reference numerals as much as possible even if they are shown in different drawings. In addition, when describing the embodiments disclosed in this document, if a specific description of a related known configuration or function is determined to hinder understanding of the embodiments disclosed in this document, the detailed description thereof is omitted.

In describing the components of the embodiments disclosed in this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

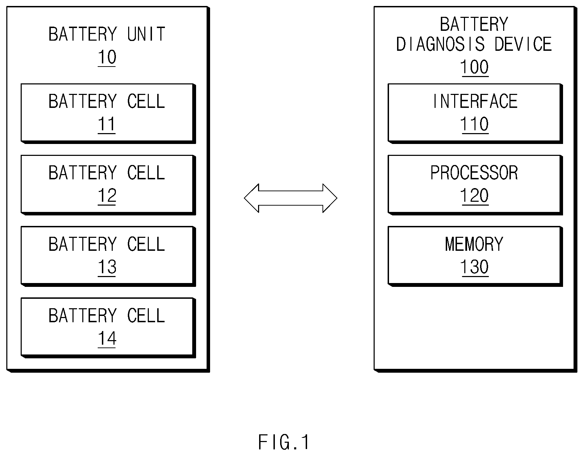

FIG. 1 is a diagram for describing a battery diagnosis device and peripheral configuration thereof according to an embodiment disclosed in this document.

Referring to FIG. 1, a battery diagnosis device 100 may be configured to diagnose a battery unit 10.

The battery unit 10 may include a plurality of battery cells 11, 12, 13, and 14. In FIG. 1, the battery unit 10 is illustrated as including four battery cells, but is not limited thereto, and the battery unit 10 may include n (n is a natural number of 2 or more) battery cells. In addition, the battery unit 10 may be implemented in the form of a battery module, a battery bank, and/or a battery pack, but is not limited thereto.

The plurality of battery cells 11, 12, 13, and 14 may be, but are not limited to, Li-ion batteries, Li-ion polymer batteries, Ni-Cd batteries, nickel metal hydride (Ni-MH) batteries, etc. In addition, although a battery pack 1 in FIG. 1 is illustrated as including one battery unit 10, the battery pack 1 may include n (n is a natural number of 2 or more) battery modules according to an embodiment.

The battery unit 10 may be included in the battery pack 1 and configured to supply power to a target device (not shown). To this end, the battery pack 1 may be electrically connected to the target device. Here, the target device may include any electrical, electronic, or mechanical device that operates by receiving power from the battery pack 1. For example, the target device may be a two-wheeled electric vehicle such as an electric vehicle (EV) or an electric scooter, but is not limited thereto. In addition, when the target device is a two-wheeled electric vehicle such as an electric scooter, the battery pack 1 mounted on the two-wheeled electric vehicle may be replaceable through a battery swapping station (BSS).

The battery diagnosis device 100 may be configured to diagnose the battery unit 10 and/or the plurality of battery cells 11, 12, 13, and 14.

According to an embodiment, the battery diagnosis device 100 may be implemented as a battery management system (BMS) that manages and/or controls a state and/or operation of the battery unit 10 and/or the plurality of battery cells 11, 12, 13, and 14. In this case, the battery diagnosis device 100 and the battery unit 10 may be implemented as one battery pack 1, and the battery diagnosis device 100 may be implemented as a module BMS or a pack BMS, but is not limited thereto.

When the battery diagnosis device 100 is implemented as a battery management system (BMS), the battery diagnosis device 100 may manage and/or control the state and/or operation of the battery unit 10. For example, the battery diagnosis device 100 may manage and/or control the state and/or operation of the plurality of battery cells 11, 12, 13, and 14 included in the battery unit 10, or manage charging and/or discharging of the battery unit 10.

In addition, the battery diagnosis device 100 may monitor the voltage, current, temperature, etc. of the battery unit 10 and each of the plurality of battery cells 11, 12, 13, and 14. To this end, sensors or various measuring modules not shown in FIG. 1 may be additionally installed at any location or in a charging and discharging path inside the battery unit 10 or the battery pack 1.

In addition, the battery diagnosis device 100 may calculate parameters indicating the state of the battery unit 10, such as the state of charge (SOC) or state of health (SOH), based on measured values such as monitored voltage, current, and temperature.

According to an embodiment, the battery diagnosis device 100 may be formed separately from the battery pack 1. In this case, the battery diagnosis device 100 may be connected to the battery unit 10 and/or the battery pack 1 including the battery unit 10 through a wired and/or wireless network, etc., and may be implemented through various devices such as a cloud server, a charger, and a charger/discharger.

The battery diagnosis device 100 may include an interface 110, a processor 120, and a memory 130.

The interface 110 may acquire voltage data of each of the plurality of battery cells 11, 12, 13, and 14.

According to an embodiment, the interface 110 may acquire voltage data by applying voltage and/or current to the plurality of battery cells 11, 12, 13, and 14. In this case, the interface 110 may include various circuits for applying voltage and/or current to the plurality of battery cells 11, 12, 13, and 14 and a processor for computing and/or processing the acquired voltage data.

According to an embodiment, the interface 110 may indirectly acquire voltage data of each of the plurality of battery cells 11, 12, 13, and 14. In this case, the interface 110 may further include a communication module for communicating with the battery pack 1 in a wired manner and/or wirelessly.

Voltage data may include, but is not limited to, changes in voltage of each of the plurality of battery cells 11, 12, 13, and 14 over time or open circuit voltage (OCV) of each of the plurality of battery cells 11, 12, 13, and 14. The interface 110 may measure and/or predict the voltage of each of the plurality of battery cells 11, 12, 13, and 14 based on the current flowing through the battery pack 1 and/or the internal resistance thereof.

According to an embodiment, the open circuit voltage (OCV) may be a voltage in a state where no external load or external circuit is connected to the plurality of battery cells 11, 12, 13, and 14 and/or in a resting state where no charging or discharging is performed on the plurality of battery cells 11, 12, 13, and 14.

According to an embodiment, the open circuit voltage of each of the plurality of battery cells 11, 12, 13, and 14 may be used to estimate a charging capacity, estimate the remaining lifespan, or perform a battery management function such as a cell balancing function, but is not limited thereto.

The processor 120 may control the overall operation of the battery diagnosis device 100. Here, the processor 120 may execute software to control the operation of at least one other component (e.g., hardware or software) of the battery diagnosis device 100, or perform operations such as processing and/or computing various data. In addition, referring to FIG. 1, the battery diagnosis device 100 is illustrated as including one processor 120, but is not limited thereto, and the battery diagnosis device 100 may include a plurality of processors.

The processor 120 may be configured to detect abnormal voltage data among the voltage data of each of the plurality of battery cells 11, 12, 13, and 14 acquired by the interface 110. The processor 120 may detect abnormal voltage data by processing and/or computing data related to the open circuit voltage of each of the plurality of battery cells 11, 12, 13, and 14 included in the voltage data of each of the plurality of battery cells 11, 12, 13, and 14. Here, the abnormal voltage data may be identified based on, but is not limited to, a shape or the like of an open circuit voltage graph of each of the plurality of battery cells 11, 12, 13, and 14.

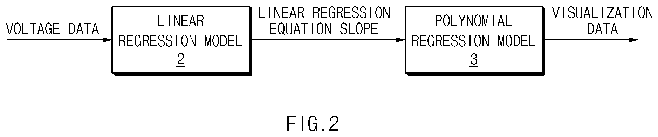

The processor 120 may extract a polynomial based on the voltage data of each of the plurality of battery cells 11, 12, 13, and 14, that is, the open circuit voltage graph of each of the plurality of battery cells 11, 12, 13, and 14. According to an embodiment, the processor 120 may extract a polynomial by inputting the voltage data of each of the plurality of battery cells 11, 12, 13, and 14 into a linear regression analysis model and a polynomial regression analysis model. Details related to this will be described below in the description of FIGS. 2 to 5.

The processor 120 may compute a distance between visualization data of the extracted polynomial and visualization data of a previously stored reference polynomial. According to an embodiment, the processor 120 may compute the distance between visualization data of the polynomial and visualization data of the reference polynomial using the dynamic time warping (DTW) algorithm, but is not limited thereto. Here, the DTW algorithm is an algorithm that measures the similarity between different waveforms, and may be an algorithm that compares the similarity using not only data from the same time series but also data from the same time series and its surrounding time lines as a comparison target. That is, the processor 120 may determine a difference in shape between the visualization data of the polynomial and the visualization data of the reference polynomial by computing the distance between the visualization data of the polynomial and the visualization data of the reference polynomial using the DTW algorithm. The DTW algorithm has an advantage capable of measuring the similarity between waveforms of different lengths compared to when determining the similarity between different time series signals using the Euclidean distance. Distance may be used to refer to similarity, however, the embodiments of the present document are not limited thereto.

The distance calculated using the DTW algorithm may indicate the degree of similarity between different waveforms. When the calculated distance is relatively low, it may indicate that shapes of the different waveforms are relatively similar, and when the calculated distance is relatively high, it may indicate that shapes of the different waveforms are relatively different.

According to an embodiment, voltage data of each of the plurality of battery cells 11, 12, 13, and 14 acquired by the interface 110 may include data related to the open circuit voltage of each of the plurality of battery cells 11, 12, 13, and 14 at the middle of life (MOL).

According to an embodiment, the reference polynomial may be derived based on the open circuit voltage of each of the plurality of battery cells 11, 12, 13, and 14 at the beginning of life (BOL).

Therefore, the visualization data of the polynomial extracted based on the voltage data may include data related to a graph of a polynomial extracted based on a graph of the open circuit voltage of each of the plurality of battery cells 11, 12, 13, and 14 at the MOL. The visualization data of the reference polynomial may include data related to the graph of the polynomial extracted based on the graph of the open circuit voltage of each of the plurality of battery cells 11, 12, 13, and 14 at the BOL.

The processor 120 may detect abnormal voltage data based on the comparison result between the computed distance and a reference distance. Here, the reference distance is not limited to a specific value and may be set and applied in various ways depending on the design.

According to an embodiment, since the distance is a value indicating the similarity of the shape between different waveforms, theoretically, the distance may correspond to any value between 0 and infinity. Accordingly, the processor 120 may calculate a distance parameter by taking a reciprocal of the computed distance. The distance parameter may correspond to a value between 0 and 1, and the more similar the shape between different waveforms, that is, the smaller the distance value, the more the distance parameter may converge to 1, and the more dissimilar the shape between different waveforms, that is, the larger the distance value, the more the distance parameter may converge to 0. The processor 120 may be configured to detect abnormal voltage data by comparing the distance parameter obtained by taking the reciprocal of the distance and a reference distance parameter obtained by taking the reciprocal of the reference distance.

According to an embodiment, the battery diagnosis device 100 may transmit abnormal voltage data and/or a degradation degree (e.g., SOH) among the voltage data of each of the plurality of battery cells 11, 12, 13, and 14 to an external device (e.g., a cloud server or a user terminal). The cloud server may be configured to provide the degradation degree or abnormal voltage data of each of the plurality of battery cells 11, 12, 13, and 14 to a plurality of users. Here, the user terminal may include a terminal device such as a personal computer (PC) or a smartphone, but is not limited thereto.

According to an embodiment, when the battery diagnosis device 100 is implemented through the cloud server, the battery diagnosis device 100 may be configured to detect abnormal voltage data among voltage data collected from various target devices (e.g., electric vehicles, etc.).

According to an embodiment, the battery diagnosis device 100 may be implemented through the battery swapping station (BSS). Here, the BSS may be a system having a slot into which a battery pack 1 may be inserted and capable of charging the inserted battery pack 1.

The memory 130 may store various data (e.g., instructions, regression analysis models, voltage data, data related to reference values) for the operation of the battery diagnosis device 100. According to an embodiment, the memory 130 may include, but is not limited to, a volatile memory device such as a static random access memory (SRAM) or a dynamic random access memory (DRAM) or a non-volatile memory device such as a read only memory (ROM), a programmable ROM (PROM), or a flash memory.

FIG. 2 is a diagram for describing a process of processing voltage data according to an embodiment disclosed in this document.

The battery diagnosis device 100 (see FIG. 1) may process voltage data of each of the plurality of battery cells 11, 12, 13, and 14 to extract visualization data. Here, the voltage data may include, but is not limited thereto, data related to the open circuit voltage of each of the plurality of battery cells 11, 12, 13, and 14, such as the open circuit voltage graph of each of the plurality of battery cells 11, 12, 13, and 14.

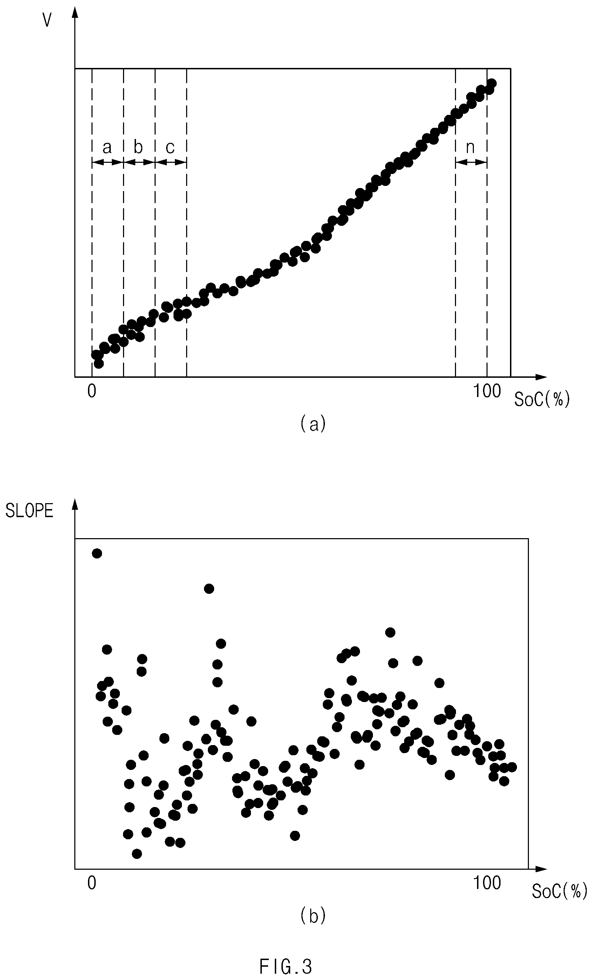

The battery diagnosis device 100 may calculate a slope of each of the plurality of linear regression equations by inputting the acquired voltage data into a linear regression model 2. Here, the linear regression model 2 may be a model that models the correlation between a dependent variable and an independent variable as a single linear equation. In this regard, referring to FIG. 3, a process of deriving a slope of a linear regression equation according to an embodiment is illustrated.

According to an embodiment, a graph (a) illustrated at the top of FIG. 3 represents an open circuit voltage graph of any battery cell, and a graph (b) illustrated at the bottom of FIG. 3 corresponds to a graph representing a slope of a linear regression equation calculated by inputting the open circuit voltage graph into the linear regression model 2 (see FIG. 2).

First, looking at the open circuit voltage graph (a) illustrated at the top, the horizontal axis represents the state of charge (SoC) of the battery cell, and the vertical axis represents the open circuit voltage (V). Looking at the slope graph (b) illustrated at the bottom, the horizontal axis represents the SoC of the battery cell, and the vertical axis represents the slope value.

The battery diagnosis device 100 (see FIG. 1) may divide voltage data into a plurality of sub-voltage data. According to an embodiment, the battery diagnosis device 100 may divide the open circuit voltage graph (a) included in the voltage data into a plurality of sections according to the SoC of the battery cell.

According to an embodiment, the battery diagnosis device 100 may divide the SoC of the battery cell into regular intervals and generate each sub-voltage data. The battery diagnosis device 100 may generate one sub-voltage data for each regular SoC interval, and the battery diagnosis device 100 may identify sub-voltage data corresponding to each of sections a, b, c, ... n, that is, an open circuit voltage graph corresponding to each section.

For example, the battery diagnosis device 100 may divide the open circuit voltage graph for each 0.5% SoC interval, but is not limited thereto. In this case, the battery diagnosis device 100 may divide one open circuit voltage data into 200 pieces of sub-voltage data.

The battery diagnosis device 100 may input each divided sub-voltage data into the linear regression analysis model 2 (see FIG. 2). According to an embodiment, the battery diagnosis device 100 may derive each linear regression equation by inputting a plurality of sub-voltage data into the linear regression analysis model 2, and may plot a slope of the derived linear regression equation on a graph.

For example, when the battery diagnosis device 100 generates sub-voltage data for each 0.5% SoC interval, 200 linear regression equations may be derived. The battery diagnosis device 100 may generate a graph such as the graph (b) shown on the right by calculating the slope of the linear regression equation corresponding to each SoC.

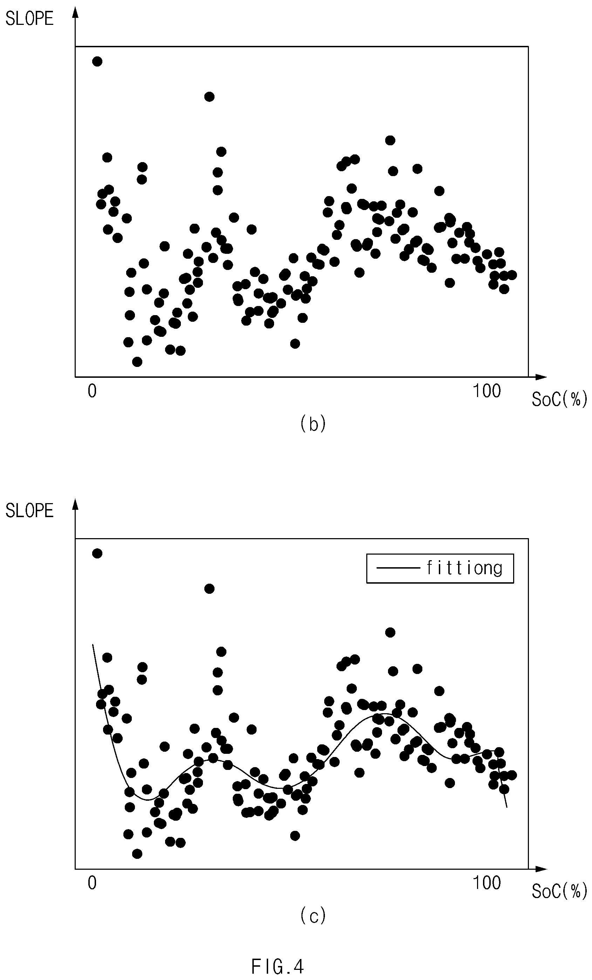

Referring to FIG. 2 again, the battery diagnosis device 100 may calculate visualization data by inputting the slope of each of the plurality of linear regression equations described with reference to FIG. 3 into a polynomial regression analysis model 3. Here, the polynomial regression analysis model 3 may be a model that models the correlation between the independent variable and the dependent variable in a nonlinear form as a polynomial. In this regard, referring to FIG. 4, a process of deriving a polynomial according to an embodiment is illustrated.

According to an embodiment, the graph (b) shown at the top of FIG. 4 may be a graph (b) representing the slope of each of the plurality of linear regression equations described with reference to FIG. 3. In addition, the graph (c) shown at the bottom may represent a graph of a polynomial acquired by inputting the graph (b) representing the slope of each of the plurality of linear regression equations into the polynomial regression analysis model 3 (see FIG. 2).

The battery diagnosis device 100 (see FIG. 1) may derive one polynomial by inputting the slope of each of the plurality of linear regression equations into the polynomial regression analysis model 3. Here, the polynomial may be a nth-order polynomial (where, n is an integer of 2 or more) representing the correlation between the SoC of the battery cell and the slope of the linear regression equation of each sub-voltage data, and the value of n is not limited to a specific value.

According to an embodiment, the graph (c) of the polynomial derived by inputting the slope of each of the plurality of linear regression equations into the polynomial regression analysis model 3 may correspond to the visualization data described with reference to FIGS. 1 and 2.

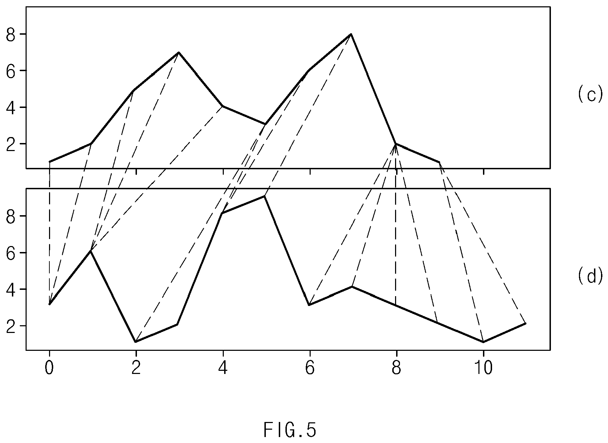

FIG. 5 is a diagram for describing a process of computing a distance according to an embodiment disclosed in this document.

The battery diagnosis device 100 (see FIG. 1) may compute the distance between the visualization data described with reference to FIG. 4 and the visualization data of the reference polynomial. Here, the graph (c) illustrated at the top of FIG. 5 may correspond to the visualization data described with reference to FIG. 4, and the graph (d) illustrated at the bottom may correspond to the visualization data of the reference polynomial.

According to an embodiment, the reference polynomial may be derived through the process of deriving the visualization data described with reference to FIG. 2. That is, the reference polynomial may be a polynomial derived by inputting the slope of each of the plurality of linear regression equations, which is calculated by inputting reference voltage data into the linear regression analysis model 2 (see FIG. 2), into the polynomial regression analysis model 3 (see FIG. 2).

According to an embodiment, the battery diagnosis device 100 may compute the distance using the dynamic time warping (DTW) algorithm. As shown in FIG. 5, when computing the distance using the DTW algorithm, not only the distance on the same time series axis but also the distance in the neighboring time series may be considered. The battery diagnosis device 100 may calculate the distance between the visualization data of the polynomial and the visualization data of the reference polynomial using the DTW algorithm. The distance may be computed using a Euclidean distance and a warping path between different waveforms, and may correspond to a distance value when the warping path is minimized.

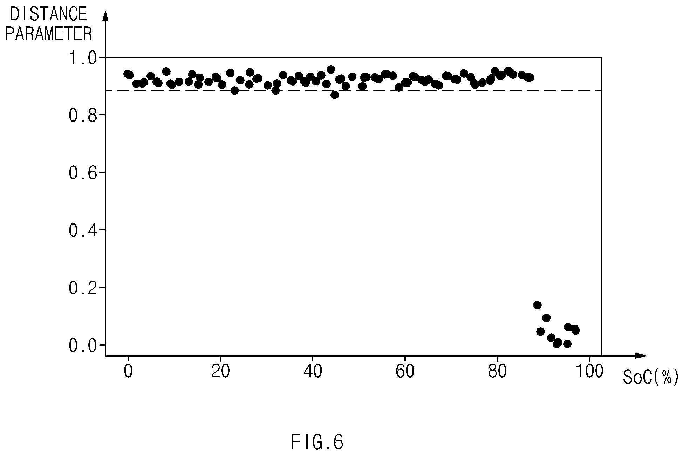

FIG. 6 is a diagram for describing a process of detecting abnormal voltage data according to an embodiment disclosed in this document.

As described with reference to FIG. 1, since the distance is a value indicating the similarity of the shape between different waveforms, theoretically, the distance may correspond to any value between 0 and infinity. Therefore, the battery diagnosis device 100 may compute the distance parameter by taking the reciprocal of the computed distance. The distance parameter may correspond to a value between 0 and 1, and the more similar the shape between different waveforms, that is, the smaller the distance value, the more dissimilar the shape between different waveforms, that is, the larger the distance value, the more the distance parameter may converge to 0. The processor 120 may be configured to detect abnormal voltage data by comparing the distance parameter obtained by taking the reciprocal of the distance and the reference distance parameter obtained by taking the reciprocal of the distance.

According to an embodiment, the battery diagnosis device 100 may compute the distance parameter by taking the reciprocal of the computed distance. For convenience of description, a value obtained by taking the reciprocal of the reference distance is assumed to be 0.9, but is not limited thereto.

As shown in FIG. 6, the battery diagnosis device 100 may detect voltage data of battery cells having a distance parameter value higher than the reference distance parameter as normal voltage data, and detect voltage data of battery cells having a distance parameter value lower than the reference distance parameter as abnormal voltage data.

Battery cells may exhibit abnormal open circuit voltage behavior as the battery cells are operated in various environments. While it is inefficient to detect battery cells that exhibit abnormal behavior by analyzing the shape of the open circuit voltage graph of the battery cell, the battery diagnosis device 100 according to an embodiment disclosed in this document can efficiently detect a battery cell having an open circuit voltage indicating an abnormal shape by using a similarity value calculated using the DTW algorithm.

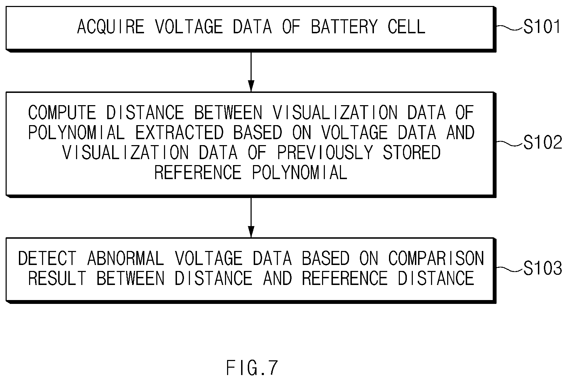

FIG. 7 is a flowchart for describing an operation of a battery diagnosis device according to an embodiment disclosed in this document.

In step S101, the battery diagnosis device 100 (see FIG. 1) may acquire voltage data of each of a plurality of battery cells 11, 12, 13, and 14. According to an embodiment, the voltage data may include, but is not limited to, data related to the open circuit voltage (OCV) of each of the plurality of battery cells 11, 12, 13, and 14 at the middle of life (MOL).

In step S102, the battery diagnosis device 100 may compute a distance between visualization data of a polynomial extracted based on the voltage data and visualization data of a previously stored reference polynomial.

According to an embodiment, the computing of the distance may include dividing the voltage data into a plurality of sub-voltage data according to an SoC of the battery cell, calculating a slope of each of a plurality of linear regression equations acquired by inputting each of the plurality of sub-voltage data into a linear regression analysis model, and deriving the visualization data of the polynomial based on the slope of each of the linear regression equations.

According to an embodiment, the visualization data of the polynomial may include data related to a graph of the polynomial derived by inputting the slope of each of the plurality of linear regression equations into a polynomial regression analysis model.

According to an embodiment, the reference polynomial may correspond to a polynomial acquired by dividing an open circuit voltage (OCV) graph of a battery cell at the beginning of life (BOL) into a plurality of sub-voltage data according to the state of charge (SoC) of the battery cell, calculating a slope of each of the plurality of linear regression equations by inputting each sub-voltage data into a linear regression analysis model, and inputting the slope of each of the plurality of linear regression equations into the polynomial regression analysis model.

According to an embodiment, the battery diagnosis device 100 may compute the distance using the dynamic time warping (DTW) algorithm.

In step S103, the battery diagnosis device 100 may detect abnormal voltage data based on the comparison result between the distance and the reference distance. Here, the reference distance is not limited to a specific value and may be set and applied in various ways depending on the design.

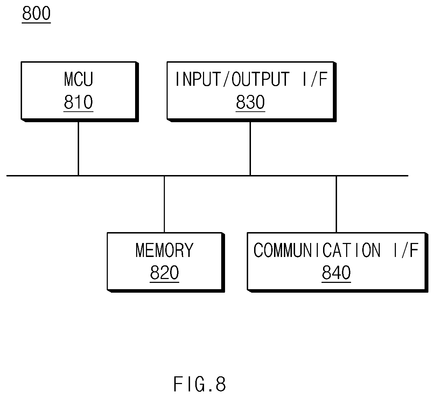

FIG. 8 is a diagram for describing a computing system equipped with a battery diagnosis device according to an embodiment disclosed in this document.

Referring to FIG. 8, a computing system 800 may include an MCU 810, a memory 820, an input/output I/F 830, and a communication I/F 840.

The MCU 810 may be a processor that executes various programs (e.g., battery diagnostic program, etc.) stored in the memory 820, processes various data for detecting abnormal voltage data among voltage data of the plurality of battery cells 11, 12, 13, and 14 (see FIG. 1) through these programs, and performs functions of the battery diagnosis device 100 described with reference to FIG. 1.

The memory 820 may store various programs for detecting abnormal voltage data. In addition, the memory 820 may store various data generated in the process of detecting abnormal voltage data, for example, information on a linear regression equation, a polynomial regression equation, a slope, etc.

A plurality of memories 820 may be provided as needed. The memory 820 may be a volatile memory or a nonvolatile memory. The memory 820 as a volatile memory may be RAM, DRAM, SRAM, or the like. The memory 820 as a nonvolatile memory may be ROM, PROM, EAROM, EPROM, EEPROM, flash memory, or the like. The examples of the memories 820 listed above are only examples and are not limited to these examples.

The input/output I/F 830 may provide an interface that enables data to be transmitted and received between an input device (not shown) such as a keyboard, mouse, or touch panel and an output device (not shown) such as a display and the MCU 810.

The communication I/F 840 is a configuration that can transmit and receive various data with a server, and may be various devices that can support wired or wireless communication. For example, programs or various data for predicting abnormal voltage data of a battery cell can be transmitted and received from a separately provided external server through the communication I/F 840.

In this way, the battery cell abnormality detection method according to an embodiment disclosed in this document can be recorded in the memory 820 and executed by the MCU 810.

In the above, all components constituting the embodiment have been described as being combined as one or operating in combination, but are not necessarily limited to such an embodiment, and may operate by selectively combining one or more of them within the scope of the purpose. The terms "include," "configure," or "have" described above, unless specifically stated to the contrary, mean that the corresponding component may be included therein, and therefore should be interpreted as further including other components rather than excluding other components.

The above description is merely an illustrative description of the technical idea disclosed in this document, and those skilled in the art to which the embodiments disclosed in this document belong may make various modifications and variations without departing from the essential characteristics of the embodiments disclosed in this document.

Accordingly, the embodiments disclosed in this document are not intended to limit the technical ideas of the embodiments disclosed in this document, but rather to describe them, and the scope of the technical ideas disclosed in this document is not limited by these embodiments. The scope of protection of the technical ideas disclosed in this document should be interpreted by the scope of the claims below, and all technical ideas within the scope equivalent thereto should be interpreted as being included in the scope of the rights of this document.

## Claims

1. A battery diagnosis device comprising:
an interface configured to acquire voltage data of a battery cell; and
a processor configured to compute a distance between visualization data of a polynomial extracted based on the voltage data and visualization data of a previously stored reference polynomial, and detect abnormal voltage data based on a comparison result between the distance and a reference distance.

2. The battery diagnosis device of claim 1, wherein the processor is configured to divide the voltage data into a plurality of sub-voltage data according to a state of charge (SoC) of the battery cell, and calculate a slope of each of a plurality of linear regression equations acquired by inputting each sub-voltage data into a linear regression analysis model.

3. The battery diagnosis device of claim 2, wherein the processor is configured to derive the visualization data by inputting the slope of each of the plurality of linear regression equations into a polynomial regression analysis model.

4. The battery diagnosis device of claim 3, wherein the visualization data includes data related to a graph of a polynomial derived by inputting the slope of each of the plurality of linear regression equations into the polynomial regression analysis model.

5. The battery diagnosis device of claim 1, wherein the processor is configured to compute a distance between the visualization data of the polynomial and the visualization data of the reference polynomial based on a dynamic time warping (DTW) algorithm.

6. The battery diagnosis device of claim 5, wherein the processor is configured to calculate a distance parameter by taking a reciprocal of each of the computed distances, and detect the abnormal voltage data based on a comparison result between the distance parameter and a reference distance parameter calculated based on the reference distance.

7. The battery diagnosis device of claim 1, wherein the voltage data of the battery cell includes data related to an open circuit voltage (OCV) of the battery cell at the middle of life (MOL).

8. The battery diagnosis device of claim 1, wherein the visualization data of the reference polynomial includes data related to a graph of a polynomial derived by dividing an open circuit voltage (OCV) graph of a battery cell at the beginning of life (BOL) into a plurality of sub-voltage data according to a state of charge (SoC) of the battery cell, calculating a slope of each of a plurality of linear regression equations by inputting each sub-voltage data into a linear regression analysis model, and inputting the slope of each of the plurality of linear regression equations into a polynomial regression analysis model.

9. An operating method of a battery diagnosis device, comprising:
acquiring voltage data of a battery cell;
computing a distance between visualization data of a polynomial extracted based on the voltage data and visualization data of a previously stored reference polynomial; and
detecting abnormal voltage data based on a comparison result between the distance and a reference distance.

10. The operating method of claim 9, wherein the computing of the distance includes:
dividing the voltage data into a plurality of sub-voltage data according to a state of charge (SoC) of the battery cell;
calculating a slope of each of a plurality of linear regression equations acquired by inputting each of the plurality of sub-voltage data into a linear regression analysis model; and
deriving the visualization data of the polynomial based on the slope of each of the plurality of linear regression equations.

11. The operating method of claim 10, wherein the visualization data of the polynomial includes data related to a graph of a polynomial derived by inputting the slope of each of the plurality of linear regression equations into a polynomial regression analysis model.

12. The operating method of claim 9, wherein the computing of the distance includes computing a distance between the visualization data of the polynomial and the visualization data of the reference polynomial based on a dynamic time warping (DTW) algorithm.

13. The operating method of claim 9, wherein the voltage data of the battery cell includes data related to an open circuit voltage (OCV) of the battery cell at the middle of life (MOL).

14. The operating method of claim 9, wherein the reference polynomial includes data related to a graph of a polynomial acquired by dividing an open circuit voltage (OCV) graph of a battery cell at the beginning of life (BOL) into a plurality of sub-voltage data according to the state of charge (SoC) of the battery cell, calculating a slope of each of a plurality of linear regression equations by inputting each sub-voltage data into a linear regression analysis model, and inputting the slope of each of the plurality of linear regression equations into a polynomial regression analysis model.
